# EUROPEAN PATENT SPECIFICATION

(11) **EP 3 730 951 B1**
(45) Date of publication and mention of the grant of the patent: **06.11.2024**
(21) Application number: 20171383.1
(22) Date of filing: 24.04.2020
(51) Int. Cl.: G01R 31/08, G01R 21/133, G01R 19/25

(54) **MEASUREMENT DEVICE, MEASUREMENT DEVICE CONTROL METHOD, AND MEASUREMENT DEVICE CONTROL PROGRAM**
MESSVORRICHTUNG, MESSVORRICHTUNGSSTEUERUNGSVERFAHREN UND MESSVORRICHTUNGSSTEUERUNGSPROGRAMM
DISPOSITIF DE MESURE, PROCÉDÉ DE COMMANDE DE DISPOSITIF DE MESURE ET PROGRAMME DE COMMANDE DE DISPOSITIF DE MESURE

(30) Priority: 26.04.2019 JP 2019086766
(43) Date of publication of application: 28.10.2020
(73) Proprietor: Informetis Co., Ltd., Tokyo 108-0014 (JP)
(72) Inventor: Inoue, Yasuhiko, Tokyo, 108-0014 (JP); Ono, Tomoyuki, Tokyo, 108-0014 (JP)
(74) Representative: AWA Sweden AB

(56) References cited:
- WO-A1-2017/115163
- US-A1- 2012 188 095
- US-A1- 2012 268 106
- US-A1- 2013 018 609
- US-A1- 2015 102 803
- US-A1- 2015 295 705
- US-A1- 2016 204 606

## Description

### BACKGROUND OF THE INVENTION

### Field of the Invention

The present invention relates to a measurement device, a measurement device control method, and a measurement device control program.

### Background

A technique has been proposed to measure current flowing to a master of a distribution board and estimate the current flowing to electric devices separately in recent years. A major advantage is that the measurement of the master of the distribution board allows an operator to acquire the power consumption in the facility for each device.

For example, Patent Document 1 discloses a signal processing system for estimating the operating status of each of the electric devices by using a portion of the master in the power line supplied from a power supply to a plurality of electric devices as a measurement point and separating the waveform data of the current and voltage at the measurement point sampled at a predetermined waveform starting point into waveform data for each device. The waveform data can be separated by normalizing the waveform data starting from the waveform starting point and comparing it with the waveform pattern of each electric device.

In contrast, as the number of electric devices connected to the power lines increases, multiple measurement points for sampling the waveform data in the power lines may be set to compute the multiple waveform data. For example, when a power generator using solar light or an electric device such as an electric car is connected to the master, noise generated by the power conditioner that performs power conversion such as frequency conversion may enter the master. It is effective to add a measurement point in the vicinity of the power conditioner and subtract the waveform data in the vicinity of the noise source from the waveform data in the master to cancel the noise in the waveform data in the master.

In addition, power equipment such as power conditioners and smart meters, which convert the power generated by the power generator, have processing functions to adjust and measure the power waveform. For this reason, the power equipment with these processing functions can be used as a measurement device for sampling the waveform data, so that the multiple measurement points of the waveform data can be located.

When waveform data measured at multiple measurement points in the power line are computed, sampling time points for sampling the waveform data among multiple measurement devices need to be synchronized and the waveform starting points as reference time axes for computation also need to be synchronized.

For example, wired communication lines with high communication speed are provided among multiple measurement devices, and the operation of the measurement devices is controlled by communication commands with less communication delay to synchronize the sampling time points.

Each measurement device may include a precise internal clock and the sampling operation may be synchronized with the internal clock to synchronize the sampling time points. WO 2017/115163 A1 relates to a method and an apparatus for communicating a condition of a power line.

### [Prior Art Document]

### [Patent Document]

[Patent Document 1] Japanese Registered Patent No. 6219401

### SUMMARY OF THE INVENTION

### [Problem to be Solved by the Invention]

However, when the multiple measurement devices are provided at a distance or in isolated locations such as the inside and outside of a building, it may be difficult to provide a wired communication line. In addition, in the case of wireless communication, it may be difficult to synchronize the sampling time points due to communication delays caused depending on the communication conditions and processing delays caused depending on the communication loads.

Further, the precise internal clocks are high in cost, and thus the costs for such clocks may increase if they are provided in the measurement devices.

Moreover, even if the sampling time points are synchronized among multiple measurement devices, it may be out of synchronization due to factors such as rebooting of the measurement devices, reducing the robustness of the system.

An object of the present invention is to provide a measurement device, a measurement device control method, and a measurement device control program, which allow sampling time points at a plurality of measurement points for sampling waveform data in power line to be easily synchronized, improving robustness.

### [Means for Solving the Problem]

The invention is defined by the appended claims.
(1) To achieve the above object, a measurement device according to an embodiment includes: a sampling portion configured to sample a waveform of at least one of voltage and current at a measurement point in a power line at a predetermined sampling time point; a processor configured to execute processing of the waveform sampled by the sampling portion; a setting information acquisition portion configured to acquire setting information that determines an operation; a setting retention portion configured to retain the setting information acquired by the setting information acquisition portion; and an operation controller configured to control the operation based on the setting information retained in the setting retention portion.
(2) In the measurement device according to the embodiment, the operation controller may execute an inquiry of time to be set in an internal clock to a time providing device that provides a reference time, and the setting information acquisition portion may acquire the setting information after the inquiry of time is executed.
(3) In the measurement device according to the embodiment, the setting information acquisition portion may acquire the setting information from a setting information management device communicably connected via a network.
(4) In the measurement device according to the embodiment, the sampling portion may sample the waveform at a sampling time point on a zero crossing point at which positive and negative of the waveform are reversed as reference.
(5) In the measurement device according to the embodiment, the operation controller may control, when a setting on a synchronization signal for synchronizing the sampling time point is set in the setting information, the communication of the synchronization signal between the measurement device and another measurement device that samples a waveform at a measurement point in another power line.
(6) In the measurement device according to the embodiment, the operation controller may control communication of the synchronization signal including a value of an internal clock of the other measurement device and a value of a wave number counter that counts a zero crossing point at which positive and negative of the waveform to be sampled are reversed.
(7) In the measurement device according to the embodiment, the operation controller may provide, when the setting in which the measurement device provides the synchronization signal is set in the setting information, the other measurement device with the synchronization signal based on a processing time point of the processing.
(8) In the measurement device according to the embodiment, the operation controller may provide a plurality of the other measurement devices with the synchronization signal simultaneously.
(9) In the measurement device according to the embodiment, the operation controller, when a setting for acquiring the synchronization signal is set in the setting information, may acquire a synchronization signal from the other measurement device, and adjust the processing time point of the processing based on the acquired synchronization signal.
(10) In the measurement device according to the embodiment, the operation controller may adjust the processing time point based on a zero crossing point at which positive and negative of the waveform are reversed.
(11) In the measurement device according to the embodiment, the operation controller, when a setting of a phase of the waveform to be sampled is set in the setting information, may set the phase of the waveform to be sampled by the sampling portion based on the setting information.
(12) To achieve the above object, a method of controlling a measurement device according to an embodiment, includes the steps of: sampling a waveform of at least one of voltage and current at a measurement point in a power line at a predetermined sampling time point; executing processing of the waveform sampled in the sampling step; acquiring setting information that determines an operation; retaining the setting information acquired in the setting information acquisition step; and controlling the operation based on the setting information retained in the setting retaining step.
(13) To achieve the above object, a computer-readable storage medium stores a program according to an embodiment for causing a computer to embody the functions of: sampling a waveform of at least one of voltage and current at a measurement point in a power line at a predetermined sampling time point; executing processing of the waveform sampled in the sampling function; acquiring setting information that determines an operation; retaining the setting information acquired in the setting information acquisition function; and controlling the operation based on the setting information retained in the setting retaining function.

### [Advantageous Effects of Invention]

According to one embodiment of the present invention, a measuring device can easily synchronize the sampling time point at a plurality of measuring points for sampling waveform data in a power line by sampling at least one of voltage and current of waveform at a measurement point in a power line at a predetermined sampling time point, performing processing of the sampled waveform, acquiring setting information to determine the operation, retaining the acquired setting information, and controlling the operation based on the retained setting information, improving the robustness.

### BRIEF DESCRIPTION OF THE DRAWINGS

FIG. 1 is a block diagram illustrating an example of a configuration of a measurement system including a measurement device according to an embodiment,
FIG. 2 is a block diagram illustrating an example of a software configuration of a measurement system including a measurement device according to an embodiment,
FIG. 3A is a diagram illustrating an example of adjustment of a processing time point of a base unit according to an embodiment,
FIG. 3B is a diagram illustrating an example of adjustment of a processing time point of an extension unit according to an embodiment,
FIG. 4A is a diagram illustrating an example of adjustment of a processing time point of a base unit according to an embodiment,
FIG. 4B is a diagram illustrating an example of adjustment of a processing time point of an extension unit according to an embodiment,
FIG. 5 is a diagram illustrating an example of adjustment of a processing time point of a measurement device according to an embodiment,
FIG. 6 is a sequence diagram illustrating an example of an operation of a measurement system including a measurement device according to an embodiment,
FIG. 7 is a block diagram illustrating an example of a hardware configuration of a measurement device according to an embodiment,
FIG. 8 is a flowchart illustrating an example of an operation of a setting information management device according to an embodiment,
FIG. 9 is a flowchart illustrating an example of an operation of a measurement device according to an embodiment,
FIG. 10 is a flowchart illustrating an example of an operation of a measurement device according to an embodiment,
FIG. 11 is a flowchart illustrating an example of an operation of a measurement device according to an embodiment,
FIG. 12 is a flowchart illustrating an example of an operation of a measurement device according to an embodiment, and
FIG. 13 is a diagram illustrating an example of adjustment of a processing time point of a measurement device according to an embodiment.

### DETAILED DESCRIPTION OF THE INVENTION

Hereinafter, with reference to the drawings, a measurement device, a measurement device control method, and a measurement device control program according to one embodiment of the present invention will be described in detail.

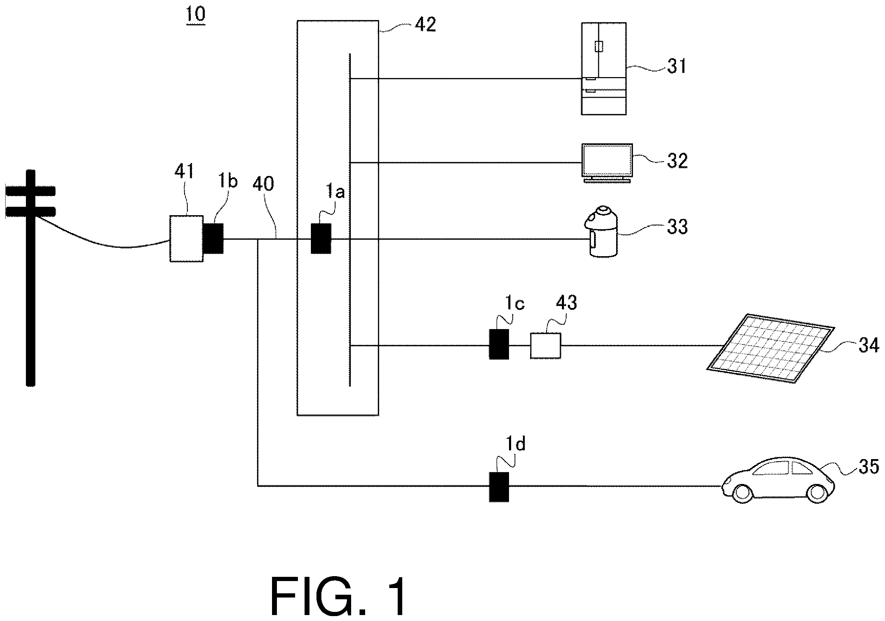

First of all, a system configuration will be described with reference to FIG. 1. FIG. 1 is a block diagram illustrating an example of a configuration of a measurement system including a measurement device according to an embodiment.

In FIG. 1, a measurement system 10 includes a measurement device 1 (measurement devices 1a to 1d). Each of the measurement devices 1a to 1d is provided to measure a voltage or current of the corresponding power line to be measured.

The measurement device 1a is connected to the power supply side of the distribution board 42 in the master 40, which is a power line connected from the load side of a smart meter 41 to the power supply side of the distribution board 42, where the power supply side of the smart meter 41 is connected to the power line (power supply) of the power company. The housing of the measurement device 1a is provided in or near the distribution board 42. The measurement device 1a measures a waveform of at least one of voltage and current on the power supply side of the distribution board 42 in the master 40 as a measurement point. The details of the measurement device 1 will be described below.

The measurement device 1b is provided in or near the smart meter 41 and measures a waveform of at least one of voltage and current on the load side of the smart meter 41 as a measurement point. The smart meter 41 is an electric power meter that digitally measures the electric power supplied to the load side and has a communication function within the meter. The smart meter 41 transmits digital data on the measured electric power usage to the management server (not shown) of the electric power company at predetermined time intervals by using a communication function. Since the measurement device 1b measures voltage or current on the load side of the smart meter 41, the measurement device 1b may utilize the function of measuring voltage and current in the smart meter 41. For example, the measurement device 1b may be implemented as a function embodied by the software of the smart meter 41.

The power supply side of the distribution board 42 is connected to the master 40, and the load side of the distribution board 42 is connected to the plural wires, and distributes the power on the power supply side to the wires. The distribution board 42 may include an earth leakage circuit breaker for preventing a short circuit, a major breaker for cutting off the current of the master, and molded case circuit breaker for cutting off the current of the wirings, which breakers are not shown. Each wiring on the load side is connected to the load side of the corresponding molded case circuit breaker provided for each wiring. Various electric devices exemplified as a refrigerator 31, a television 32, and an electric pot 33 are connected to the corresponding wirings on the load side. The distribution board 42 may be a device that serves as the smart meter 41 or a step-down transformer (e.g., a cubicle high voltage power receiving facility).

A power conditioner 43 and also a solar photovoltaic generator 34 are connected through the measurement device 1c to the wiring on the load side of the distribution board 42. Further, an electric vehicle 35 is connected from the master 40 through the measurement device 1d to the wiring on the load side of the molded case circuit breaker (not shown). The measurement device 1b and the measurement device 1d in FIG. 1 illustrate that the measurement points may be provided on the power supply side of the measurement device 1a. Moreover, the measurement device 1c illustrates that the measurement point may be provided on the load side of the measurement device 1a.

The measurement device 1c is connected to a power line in the vicinity of the power conditioner 43 and measures a waveform of at least one of voltage and current with the wiring in the vicinity of the power conditioner 43 as a measurement point. In addition, the measurement device 1d is provided in the wiring connected to the electric vehicle 35 and measures a waveform of at least one of voltage and current with the wiring connected to the electric vehicle as a measurement point.

The power conditioner 43 is an inverter that converts the power generated by the solar photovoltaic generator 34 from direct current to alternating current of commercial frequency (50 Hz or 60 Hz) and commercial voltage (single-phase 200 V or three-phase 200 V). The power conditioner 43 supplies the power generated by the solar photovoltaic generator 34 to the distribution board 42 to allow the power to be supplied to the other wirings. The power conditioner 43 may supply the power to the power lines of a power company.

The power conditioner 43 may generate switching noise when the inverter performs frequency conversion. The generated switching noise propagates through the power line while attenuating according to the impedance of the power line. The measurement device 1c uses the power line near the power conditioner 43 as a measurement point, allowing a waveform that includes the great switching noise generated by the power conditioner 43 to be measured.

In addition, the electric vehicle 35 has an on-board inverter (not shown) that converts the AC power supplied by the master 40 to DC internally. The DC power converted by the on-board inverter charges the on-board battery (not shown). In contrast, the on-board inverter converts the DC power charged in the on-board battery into AC power and supplies it to the distribution board 42. The on-board inverter may generate switching noise in the same manner as in the power conditioner 43 when the frequency conversion is performed. The measurement device 1d uses the wiring to the electric vehicle 35 as a measurement point, allowing the waveform that includes the great noise generated by the electric vehicle 35 to be measured.

Although FIG. 1 illustrates that the measurement system 10 includes four measurement devices 1 (measurement devices 1a to 1d), the number of the measurement devices 1 in the measurement system 10 is not limited to this. For example, a plurality of the measurement devices 1 may be provided as a backup in case of failure.

In addition, although FIG. 1 illustrates that the measurement device 1a is provided in or near the distribution board 42, the location of the measurement device 1a is not limited to this. For example, the measurement device 1a may be provided in or near the smart meter 41.

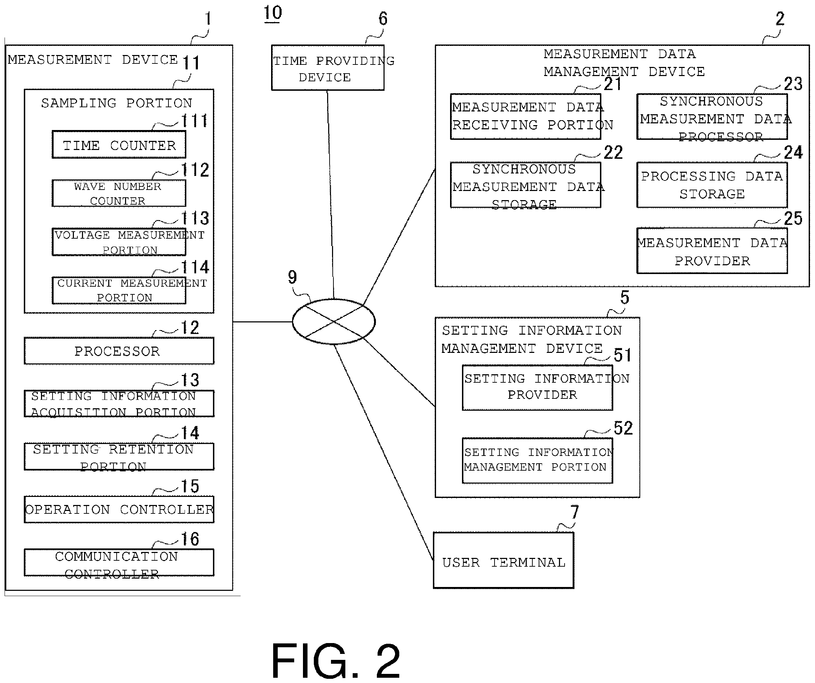

Next, a description will be given of the functions of the measurement device 1 with reference to FIG. 2. FIG. 2 is a block diagram illustrating an example of a software configuration of the measurement device 1. FIG. 2 illustrates only one measurement device 1 and omits the illustration of the other measurement devices 1.

Although FIG. 2 illustrates that the measurement system 10 includes only one measurement device 1, the measurement system 10 may include a plurality of the measurement devices 1. The measurement device 1 is communicatively connected to the other measurement devices 1 via wireless communication. The communication method of the measurement device 1 may be other than the wireless communication, and for example, include power line communication via a power line, wired communication via a LAN cable, or near field communication.

The measurement device 1 has functional portions including a sampling portion 11, a processor 12, a setting information acquisition portion 13, a setting retention portion 14, an operation controller 15, and a communication controller 16. The above functional portions of the measurement device 1 according to the present embodiment are described as functional modules embodied by a measurement device control program (software) that controls the measurement device 1.

<Measurement Device 1>

The sampling portion 11 includes a time counter 111, a wave number counter 112, a voltage measurement portion 113, and a current measurement portion 114. The sampling portion 11 samples a waveform of at least one of voltage and current at a measurement point of the power line at a predetermined sampling time point. For example, the sampling portion 11 in the measurement device 1a shown in FIG. 1 samples the waveform of the voltage or current measured with the power supply side of the distribution board 42 in the master 40 as a measurement point. The voltage measurement portion 113 samples the voltage waveform, and the current measurement portion 114 samples the current waveform. The voltage measurement portion 113 samples a voltage waveform in the range of 100 V to 200 V or 220 V to 240 V, for example. In addition, the current measurement portion 114 samples the current waveform in a current range in accordance with the current cut off by the major breaker.

The sampling portion 11 samples, for example, the voltage waveform detected by the voltage measurement portion 113 or the current waveform detected by the current measurement portion 114 at a predetermined time point (that may be referred to as sampling time point). The sampling time point is determined, for example, by the time counter 111, which counts time in seconds, and the wave number counter 112, which counts the number of waves per second. In the present embodiment, the time counter 111 and the wave number counter 112 are used to illustrate a case in which the sampling time point is set at the starting point of the waveform in the sampling slot below. The starting point of the waveform can be set at a zero crossing point described below. The wave number counter 112 with a zero crossing point as a waveform starting point may be referred to as a "zero crossing counter" that counts the zero crossing point. The waveform data to be sampled by the sampling portion 11 is, for example, analog data. In the present embodiment, when the waveform data is referred to, whether it is analog or digital data is not limited.

The processor 12 executes the processing of the waveform data sampled by the sampling portion 11 in multiple processing slots. The processing slot is a processing unit for waveform data, which is executed repeatedly in a predetermined cycle in synchronization with the waveform of the voltage or current of the power supply. The processing slot is a processing unit that is executed n times (e.g., n = 10 or n = 20) in a cycle of one second, i.e., executed in 1/n seconds. For example, in the processing slot with n=20, one processing slot is executed for a processing time of 0.05 seconds. The processing slot may be, for example, a processing unit determined by the number of clocks in the internal clock. The processor 12 repeatedly executes n processing slots from 0 to (n-1) in a predetermined cycle (e.g., one second). Although the present embodiment illustrates the case where the processing time for all the processing slots is the same, the processing time for the processing slots may be different for each processing slot.

The processing slot executed by the processor 12 may include, for example, one or more of the followings.

### (Sampling Slot)

The sampling slot is directed to a processing slot that executes the process of sampling a waveform by the sampling portion 11. In the sampling slot, the processor 12 causes the sampling portion 11 to sample the waveform at the "waveform starting point." The waveform starting point is directed to a starting point for sampling the waveform in the sampling slot. For example, the waveform starting point may be predetermined with the waveform of the voltage or current detected in the sampling slot as reference.

For example, the waveform of the power supply with a commercial frequency of 50 Hz (cycle 0.02 seconds) is included in the sampling slot 2.5 times (0.05/0.02 = 2.5) when the sampling slot is executed for 0.05 seconds. The processing slot is synchronized with the waveform of the power supply and executed. Here, the waveform starting point can be defined as "the zero crossing point where the polarity of the waveform first changes from negative to positive in the sampling slot" or "the zero crossing point where the polarity of the waveform second changes from positive to negative in the sampling slot," for example. The zero crossing point corresponds to the time point when the positive and negative of the polarity of the waveform is reversed and can be easily detected. The waveform starting point is synchronized with the waveform starting point to be adjusted in the other measurement device 1. Since the zero crossing point is easily detected, it can be easily detected by the other measurement device 1 that synchronizes the waveform starting point, thus reducing the costs of the device. Further, since the zero crossing point is set as the waveform starting point, the sampled waveform data corresponds to the waveform starting from the zero point, facilitating the processes such as normalization of the waveform data.

### (Other Processing Slots)

As for the other processing slots, the processor 12 may execute a conversion slot for converting an analog waveform sampled by the sampling portion 11 into a digital waveform (A/D conversion), a computation slot for computing the converted digital waveform, a processing slot for storing waveform data of the computed digital waveform, and a transmission slot for transmitting the computed waveform data, for example. Moreover, the conversion slot may be executed in the same processing slot as the sampling slot.

The normalization process of the waveform data will be illustrated below as an example of the computation of the digital waveform executed by the computation slot.

In one example of the normalization process of the waveform data, the processor 12 generates an approximate waveform data of the analog waveform data from the starting point to the end point of the sampled waveform, computes the normalization cycle based on the number of samples for one cycle of the analog waveform data and the waveform cycle, and further samples the approximate waveform data from the waveform starting point for the normalization cycle. The normalized waveform data is used for the separation process that separates it into waveform data for each electric device. For example, the Factorial Hidden Markov Module (HMM) may be used for the separation process of the waveform data. Specifically, the model parameters in which the operating conditions of the electric devices are modeled are prepared in advance. The Factorial HMM separates the waveform data into multiple state variables for each time sequence. The separated state variables may be compared with the model parameters that are prepared in advance to identify the electric devices. The case where the separation process above is executed in a measurement data management device 2 will be described below.

The setting information acquisition portion 13 acquires setting information that defines the operation of the measurement device 1. The setting information is directed to information that predetermines the operation of the measurement device 1, and may include, for example, the following information.

### <Setting Information on the Synchronization Signal>

The setting information may include setting information on a synchronization signal for synchronizing the sampling time points in the plurality of measurement devices 1. The synchronization signal is directed to a signal for synchronizing the sampling time points in the measurement devices 1 (details thereof will be described below). The synchronization signal is provided by the measurement device 1 to the other measurement devices 1. Here, the measurement device 1 that provides the synchronization signal to the other measurement devices 1 is referred to as a "base unit." The measurement devices 1 that acquire the synchronization signal from the base unit is referred to as "extension units." That is, the synchronization signal is provided by the base unit to the extension units. The sampling time points in the measurement devices 1 are synchronized, allowing the acquisition of the voltage waveform or the current waveform to be synchronized. The setting information on the synchronization signal is directed to information on whether the measurement device 1 corresponds to the base unit. When the setting information includes information that the measurement device 1 corresponds to the base unit, the measurement device 1 that acquires the setting information including the information that the measurement device 1 corresponds to the base unit is set as the base unit. In this case, the measurement device 1 that acquires the setting information that does not include information that the measurement device 1 corresponds to the base unit may be set as an extension unit (alternatively, the measurement device 1 that is not set as a base unit may be regarded as an extension unit implicitly). Further, the setting information may explicitly include information that the measurement device 1 corresponds to the extension unit. When the setting information includes information that the measurement device 1 corresponds to the extension unit, the measurement device 1 that acquires the setting information including the information that the measurement device 1 corresponds to the extension unit is explicitly set as the extension unit.

### <Setting Information on Setting of Phase of Waveform to be Sampled>

The setting information may include information on the setting of the phase of the waveform to be sampled. The measurement device 1 that acquires the setting information that includes information on the setting of the phase of the waveform to be sampled sets (changes) the phase of the waveform to be sampled according to the setting information. When the power line to be sampled has multiple phases, the zero crossing point of each phase has a predetermined phase difference. For example, when the power line is a three-phase three-wire type, the phases R, S, and T have a phase difference of 120 degrees, and thus the zero crossing points of the phases also have a phase difference of 120 degrees. When the power line is a single-phase three-wire type, each phase of L1 and L2 has a phase difference of 180 degrees, and thus the zero crossing points of the L1 and L2 also have a phase difference of 180 degrees. Aligning the phases of the waveforms to be sampled in the measurement devices 1 allows the sampling time points in the measurement devices 1 to be aligned.

### <Other Setting Information>

The setting information may include other information on the measurement device 1. For example, the setting information may include information for setting the time point or frequency of providing the synchronization signal, the time point of sampling (e.g., sampling interval), and an effective communication channel (a channel for transmitting the waveform data), for example. Also, the setting information may include information for stopping or starting the operation of the measurement device 1.

The setting information is provided by a setting information management device 5 communicatively connected via the network 9. The setting information management device 5 includes a setting information provider 51 and a setting information management portion 52. The setting information management portion 52 stores and manages setting information corresponding to each measurement device 1 (e.g., measurement devices 1a to 1d). In addition, the setting information management portion 52 may set and store setting information from a terminal device (not shown). The setting information provider 51 provides the setting information acquisition portion 13 with the setting information managed by the setting information management portion 52. The setting information acquisition portion 13 may acquire the setting information after the operation controller 15 has made an inquiry of a time to be set in the internal clock to a time providing device 6 that provides a reference time. The time providing device 6 is directed to, for example, a network time protocol (NTP) server. The time providing device 6 may be configured by a plurality of NTP servers.

In acquiring the setting information, for example, after the operation controller 15 has made an inquiry of the time to be set in the internal clock to the time providing device 6, the setting information acquisition portion 13 may request the setting information management device 5 to provide the setting information, and the setting information management device 5 may provide the setting information in response to the request, allowing the setting information acquisition portion 13 to acquire the setting information. For example, the setting information acquisition portion 13 transmits a Hypertext Transfer Protocol (HTTP) request to the setting information management device 5 after the inquiry of the time to be set in the internal clock has been performed. The HTTP request may include information to identify the measurement device 1, such as the manufacturer name, model or firmware version information, and serial number information, for example, as additional information of the HTTP. The setting information management device 5 may identify the setting information to be provided based on the information to identify the measurement device 1 included in the received HTTP request, and then provide the setting information acquisition portion 13 with the setting information identified as the HTTP response.

In addition, in acquiring the setting information, the setting information management device 5 may provide the setting information acquisition portion 13 with the setting information when the setting information management device 5 monitors whether the operation controller 15 has made an inquiry of the time to be set in the internal clock to the time providing device 6, and confirms that the inquiry has been made. In the present embodiment, the term "acquisition" may be either a subjective acquisition (pull type acquisition) or an active acquisition (push type acquisition). That is, the setting information acquisition portion 13 may actively receive push-type transmission of the setting information from the setting information management device 5, or it may subjectively download the setting information stored in the setting information management device 5. In the same manner, in the present embodiment, the term "provision" may be either a subjective provision (push type provision) or an active provision (pull type provision). That is, the actions of "acquisition" and "provision" do not limit the acting subject.

The setting retention portion 14 retains the setting information acquired by the setting information acquisition portion 13. The retention of the setting information may be directed to storing the setting information inside the measurement device 1, or allowing the setting information stored outside the measurement device 1 to be read. For example, the setting retention portion 14 may retain link information to a destination in which the setting information is stored.

The operation controller 15 controls the operation of the measurement device 1 based on the setting information retained in the setting retention portion. An example of the operation of the measurement device 1 controlled by the operation controller 15 will be illustrated below.

### <Time Inquiry Operation>

The operation controller 15 performs an inquiry of the time to be set in the internal clock to the time providing device 6 that provides the reference time. Specifically, for example, the operation controller 15 performs an inquiry of the time to be set in the internal clock immediately after the measurement device 1 is provided, and when a configuration of the measurement device 1 is performed (e.g., the measurement devices 1a to 1n are newly provided or changed). In addition, the operation controller 15 may check that the internal clock is not set (e.g., in the initial state), and then inquire the time.

### <Setting Operation of Base Unit or Extension Unit>

The operation controller 15 performs the operation of setting the measurement device 1 as a base unit or an extension unit when the setting for the synchronization signal is set in the setting information. The operation controller 15 sets the measurement device 1 as a base unit or an extension unit when the setting information includes information on the synchronization signal.

### <Setting Operation of Waveforms to be Sampled>

If the setting information includes information on setting of the phase of the waveform to be sampled, the operation controller 15 executes the operation to synchronize the waveform. For example, if the power line is a three-phase three-wire type, the process of delaying (or advancing) the waveform to be sampled by 120 degrees or 240 degrees is performed. Also, if the power line is a single-phase three-wire type, the waveform to be sampled is delayed (or advanced) by 180 degrees (i.e., the positive and negative of the waveform are reversed). This allows the synchronization of the waveforms to be sampled.

### <Synchronization Signal Communication Operation>

The operation controller 15 controls the communication of synchronization signal with the other measurement devices 1 when the setting for the synchronization signal is set in the setting information. The communication of the synchronization signal is directed to, for example, communication on the provision (transmission) of the synchronization signal when the measurement device 1 corresponds to the base unit. In contrast, if the measurement device 1 corresponds to the extension unit, for example, the communication of the synchronization signal is directed to communication on the acquisition (reception) of the synchronization signal. In the present embodiment, the case where the extension unit requests the acquisition of the synchronization signal from the base unit, and the base unit transmits the synchronization signal to the extension unit in response to the request is illustrated.

If the measurement device 1 corresponds to the extension unit, the operation controller 15 acquires a request to provide the synchronization signal to the other measurement device 1 communicatively connected via a network. The operation controller 15 requests the provision of the synchronization signal under certain predetermined conditions. The certain predetermined conditions requiring the provision of the synchronization signal may be directed to, for example, the elapse of a predetermined time such as every hour, a predetermined number of executions of the processing slots, or an explicit operation by an operator, such as the pressing of a reset button of the device. In contrast, when the measurement device 1 corresponds to the base unit, the operation controller 15 provides the synchronization signal based on the time point of the processing in the processing slot in response to a request from the other measurement devices 1.

The synchronization signal corresponds to information for synchronizing the processing time point of the processing slot, and may include, for example, time information, a value of a wave number (zero crossing) counter, a sampling time point, and the number of processing slots. For example, the synchronization signal may be generated based on the execution status of the processing slot of the measurement device 1. The time information is directed to, for example, a value of the internal clock included inside the measurement device 1. The value of the wave number counter is directed to, for example, the number of counted zero crossings in one second. The information on the sampling time point is directed to a value of the wave number counter, which indicates the time points of sampling.

The number of processing slot is directed to a slot number of the processing slot that is being executed in the measurement device 1. The slot number is an integer from 1 to n if the number of processing slots is n. When the cycle of the slot processing in the processor 12 is one second and the number of slots is 20 and all the processing slots are executed at the same time, the sampling slot is executed for 0.05 seconds. Here, the processing of slot 1 is executed between 0 and 0.05 seconds, with 0 seconds as the starting time of the processing. The processing of the slot number 2 is executed between 0.05 and 0.10 seconds. That is, the slot number as a synchronization signal may include a time error of up to 1/n seconds (when the cycle is one second). The synchronization signal allows the starting points of the waveforms to be roughly synchronized within an error range of 1/n. Accordingly, even if the communication between the measurement device 1 and the other measurement device 1 is delayed due to wireless communication, for example, the effect of the communication delay can be ignored as long as the delay in the wireless communication does not affect the slot number being executed.

### <Synchronized Operation>

When the measurement device 1 corresponds to the extension unit, the operation controller 15 adjusts the processing time point of the sampling process or the processing of the sampled waveform based on the acquired synchronization signal. The operation controller 15 adjusts the processing time point of the processing in the processing slot based on the synchronization signal acquired from the base unit. First, the operation controller 15 roughly synchronizes the processing time point with the starting point of the waveform within the error range of the processing time of the processing slot (1/n: where n is the number of the processing slots) based on the synchronization signal. The operation controller 15 then synchronizes the processing time point in detail based on the waveform on the zero crossing point, for example.

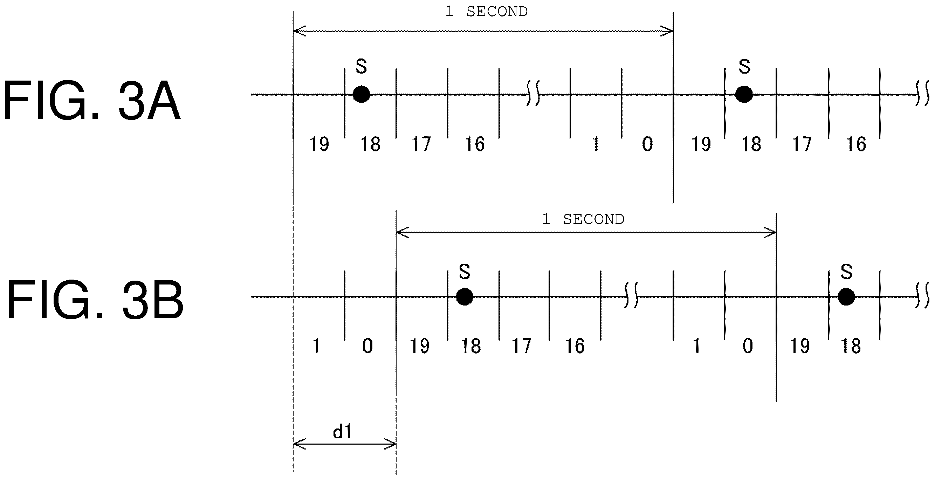

Here, with reference to FIGS. 3A to 5, the adjustment of the processing time point of the processing slots in the operation controller 15 will be described. FIGS. 3A to 4B illustrate a process in which the processing time point is roughly adjusted using the slot number of the processing slot.

FIGS. 3A and 3B are diagrams illustrating an example of a temporal discrepancy of the processing time points in the processing slots of a plurality of the measurement devices 1. FIG. 3A is a time chart illustrating the processing time point of the processing slot of the measurement device 1 (base unit). FIG. 3B is a time chart illustrating the processing time point of the processing slot of the measurement device 1 (extension unit).

In FIG. 3A, the measurement device 1 (base unit) executes 20 processing slots (slot numbers 0 to 19) for one second. That is, the processing time for one processing slot is 1/20 = 0.05 seconds. The processing slots are executed in the order of the slot number 19, 18, and 17, and after the processing slot of the slot number 0 is executed, the processing slot of the slot number 19 is executed again. The slot number 18 corresponds to a sampling slot. The black circle S in the sampling slot indicates the sampling time point of the waveform.

In FIG. 3B, the measurement device 1 (extension unit) executes 20 processing slots (slot numbers 0 to 19) for one second in the same manner as in the base unit. Here, the extension unit executes the processing slot at the delay time d1 with respect to the base unit. Accordingly, the sampling time point of the waveform is also delayed by the delay time d1. Although the delay time d in FIGS. 3A to 4B shows the case where the processing time point of the extension unit is a positive value with a delay, the delay time d may be a negative value preceded by the processing time point of the extension unit.

The delay in the execution of the processing slot occurs, for example, immediately after the extension unit is turned on (in an unsynchronized state). The delay in the execution of the processing slot occurs when the internal clock of the extension unit is out of sync with the internal clock of the base unit (synchronization is out of sync over time). The extension unit according to the present embodiment synchronizes the processing time point of the processing slot caused by the states shown in FIGS. 3A and 3B.

In the present embodiment, an object is to synchronize the processing time points of the sampling slots. Accordingly, in adjusting the processing time points in the operation controller 15, the processing slots other than the sampling slots may be different in the measurement devices 1. Even the number of processing slots may be different and the processing time for one processing slot may also be different as long as the processing time points of the sampling slots can be synchronized.

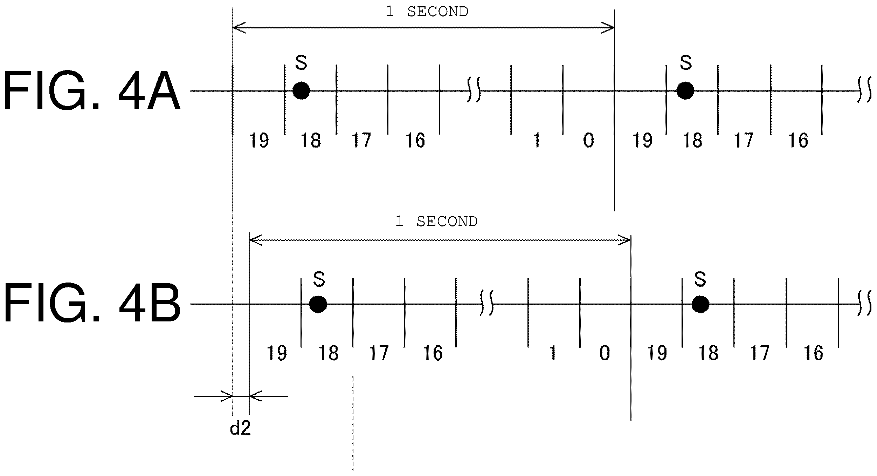

FIGS. 4A and 4B illustrate an example of adjusting the processing time point of the processing slot of the extension unit in the operation controller 15. FIG. 4A is a time chart illustrating the processing time point of the processing slot of the measurement device 1 (base unit). FIG. 4B is a time chart illustrating the processing time point of the processing slot of the measurement device 1 (extension unit) after the adjustment by the operation controller 15.

FIG. 4A is the same as FIG. 3A, and thus the description thereof is omitted. FIG. 4B shows the time chart after adjusting the delay time d2 of the processing time point to be less than 1/20 (0.05) seconds as the processing time of the processing slot using the synchronization signal. That is, d2 is < 0.05 seconds. Since the synchronization signal is directed to information indicating a processing slot being executed in the measurement device 1, the synchronization signal includes an error of 0.05 seconds depending on the time point of the request. The delay time can be ignored if the delay in acquiring the synchronization signal does not affect the slot number being executed since the operation controller 15 adjusts the processing time point roughly including this error. This allows low-cost communication methods such as wireless LANs to be used in acquiring synchronization signal.

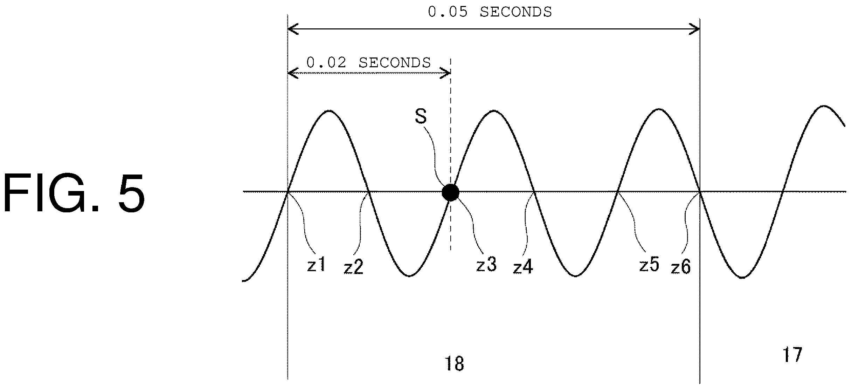

FIG. 5 illustrates an example of adjusting the processing time point of the measurement device 1 (extension unit) in the operation controller 15.

In FIG. 5, the sampling slot shown in slot number 18 is executed in synchronization with the zero crossing point of the waveform of the commercial power supply. The processing time of the sampling slot is 0.05 seconds. If the frequency of the commercial power supply is 50 Hz, one processing slot contains 2.5 cycles of waveforms. If the processing time point of the processing slot is synchronized to a zero crossing point where the polarity of the waveform reverses from negative to positive, then the sampling slot contains six zero crossing points, z1 to z6. The operation controller 15 may adjust the processing time point to the zero crossing point of z1, z3 or z5. The synchronization signal may set to which zero crossing point the processing time point may correspond. The operation controller 15 synchronizes the processing time point at the set zero crossing point, allowing the sampling time point shown in the black circle S to be synchronized with the measurement device 1. With the above, the description of FIGS. 3 to 5 is completed, returning to the description of FIG. 2.

The functional portions of the measurement device 1 described above are examples of the functional portions of each of the devices, and do not limit the functions of each of the devices. For example, the devices need not have all of the functional portions above, and thus may have some of the functional portions. In addition, the devices may have functions other than those described above.

In addition, the functional portions above are described as being embodied by software. However, the at least one or more of the functional portions above may be embodied by hardware.

Furthermore, any of the functional portions above may be implemented by dividing one functional portion into multiple functional portions. In addition, any two or more of the functional portions above may be integrated into a single functional portion to be implemented. That is, FIG. 2 shows the functions of the measurement system 10 represented by functional blocks, and does not show, for example, that each functional portion is configured by a separate program file.

The devices may be directed to a device embodied by a single enclosure, or it may be directed to a system embodied by multiple devices connected via a network, for example. For example, the measurement device 1 may embody some or all of its functions by a virtual device, such as a cloud service provided by a cloud computing system. That is, the measurement device 1 may embody at least one or more of the functional portions above in the other devices. Also, the measurement device 1 may be a general-purpose computer such as a desktop PC, or it may be a dedicated device with limited functions.

The measurement data management device 2 includes a measurement data receiving portion 21, a synchronous measurement data storage 22, a synchronous measurement data processor 23, a processing data storage 24, and a measurement data provider 25.

The measurement data receiving portion 21 receives measurement data (waveform data) transmitted from a plurality of measurement devices 1. The synchronous measurement data storage 22 stores measurement data that are measured synchronously in the measurement devices 1. For example, the synchronous measurement data storage 22 associates two waveform data measured synchronously in two measurement devices 1 with each other, and stores the associated information as well as the two waveform data.

The synchronous measurement data processor 23 processes the synchronized measurement data. For example, the synchronous measurement data processor 23 estimates the operating status of the electric devices (refrigerator 31, TV 32, and electric pot 33). As described above, the waveform data can be separated into multiple state variables for each time sequence using the Factorial HMM and compared with the model parameters prepared in advance to estimate the operating status. The synchronous measurement data processor 23 stores the model parameters of the electric devices in advance. Since new electric devices are always being released, the measurement data management device 2 may obtain the model parameters of the latest electric devices, for example, from a cloud server (not shown). The synchronous measurement data processor 23 may compute the difference between the plurality of synchronously measured measurement data, thereby reducing the influence of measurement data of the other electric devices and estimating the operating status of the target electric device.

The processing data storage 24 stores the processing data processed by the synchronous measurement data processor 23. The measurement data provider 25 provides the user terminal 7 (e.g., a desktop PC, a notebook PC, a tablet PC, and a smartphone) with the processing data stored in the processing data storage 24.

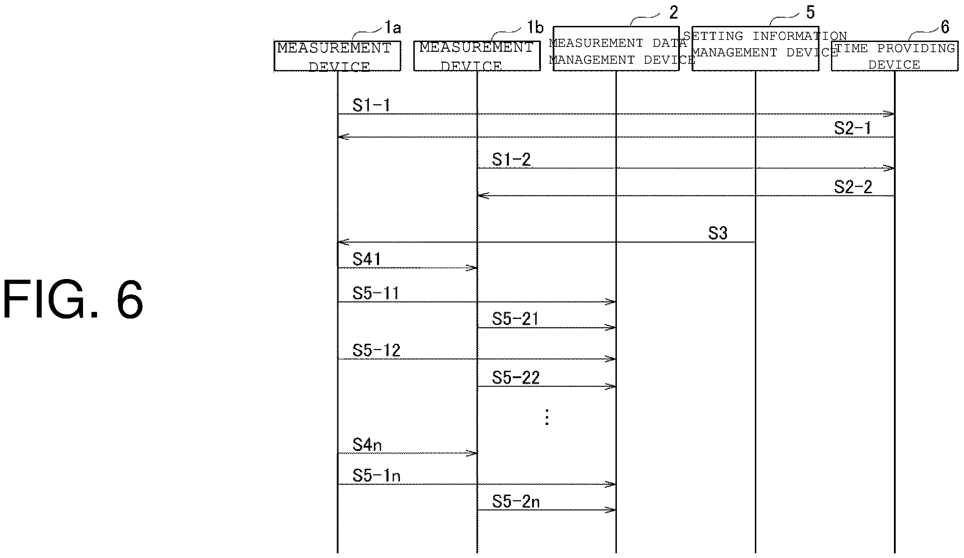

Next, with reference to FIG. 6, the operation of the measurement system 10 above will be described. FIG. 6 is a sequence diagram illustrating an example of an operation of a measurement system including a measurement device according to an embodiment.

FIG. 6 illustrates an example of the measurement system 10, in which in two measurement devices 1, i.e., a measurement device 1a and a measurement device 1b, the measurement device 1a is set as a base unit and the measurement device 1b is not explicitly set as an extension unit, i.e., is regarded as an extension unit inexplicitly.

The measurement device 1a executes a query to the time providing device 6 for a time to be set in the internal clock (step S1-1) and acquires information on the time (step S2-1). In the same manner, the measurement device 1b executes a query to the time providing device 6 for a time to be set in the internal clock (step S 1-2) and acquires information on the time (step S2-2). The processes in step S1-1 and step S 1-2 may be executed asynchronously in the state of the measurement device 1a (e.g., immediately after provided) and the state of the measurement device 1b, respectively.

The setting information management device 5 refers to the correspondence between the measurement device 1 and the setting information stored in the setting information management portion 52, and provides the measurement device 1a with the setting information including information on the synchronization signal (step S3). That is, the measurement device 1a sets itself as the base unit that provides the synchronization signal based on the provided setting information.

The measurement device 1a, which is set as the base unit, provides the measurement device 1b with the synchronization signal (step S41). The measurement device 1b sets itself as the extension unit according to a fact that it is provided with the synchronization signal.

The measurement device 1a samples the waveform at the measurement point at the sampling time point and provides the measurement data management device 2 with the waveform data (step S5-11). In addition, the measurement device 1b samples the waveform at the measurement point at the sampling time point and provides the measurement data management device 2 with the waveform data (step S5-21). The processes in step S5-11 and step S5-21 are repeated for each sampling time point (steps S5-1n and S5-2n).

The measurement device 1a provides the measurement device 1b with a synchronization signal at a predetermined time point (step S4n). The predetermined time point is directed to a time point when the sampling time points of the base unit and the extension unit are offset from each other, for example, when the power is turned on again. The base unit provides the extension unit with a synchronization signal at a predetermined time point to allow the sampling time points to be easily synchronized, improving robustness.

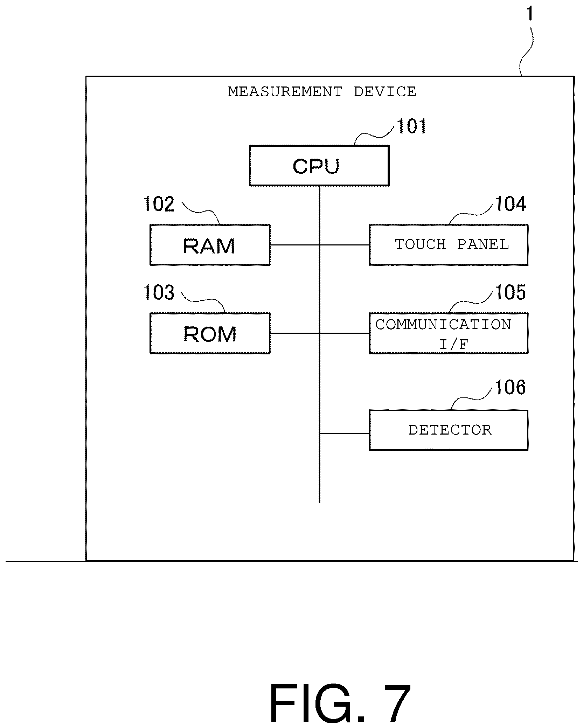

Next, with reference to FIG. 7, a hardware configuration of the measurement device 1 will be described. FIG. 7 is a block diagram illustrating an example of a hardware configuration of the measurement device 1 according to an embodiment.

The measurement device 1 includes a central processing unit (CPU) 101, a random access memory (RAM) 102, a read only memory (ROM) 103, a touch panel 104, and a communication interface (I/F) 105. The measurement device 1 is directed to a device that executes a measurement device control program that controls the measurement device 1 described in FIG. 1.

The CPU 101 controls the measurement device 1 by executing the information processing program stored in the RAM102 or the ROM103. For example, the measurement device control program is acquired from a recording medium that stores the program or a program distribution server via the network, installed in the ROM 103, read by the CPU 101, and executed.

The touch panel 104 has an operation input function and a display function (operation display function). The touch panel 104 allows the user of the measurement device 1 to input operations using a finger tip or a touch pen, for example. Although the case where the measurement device 1 according to the present embodiment uses a touch panel 104 having an operation display function will be described, the measurement device 1 may have a display device having a display function and an operation input device having an operation input function separately. In this case, the display screen of the touch panel 104 may be embodied by the display screen of the display device, and the operation of the touch panel 104 may be performed by the operation of the operation input device. Further, the touch panel 104 may be embodied in various forms such as a head-mounted display, a spectacle-shaped display, and a wristwatch-shaped display.

The communication I/F 105 is directed to an I/F for communication. The communication interface 105 executes near field communication such as wireless LAN, wired LAN, and infrared, for example. Although FIG. 7 shows that the communication I/F is only the communication I/F 105, the measurement device 1 may have an I/F for each of the multiple communication methods.

The detector 106 detects analog waveform data of the current or voltage of the power supply line. The detector 106 may, for example, measure a voltage in the range of 100 V to 200 V or 220 V to 240 V The detector 106 may measure a current with an upper limit of the contract current. The detector 106 may detect a total of three channels, for example, two channels of current and one channel of voltage, when the power supply is a single-phase three-wire power supply.

The hardware configuration shown in FIG. 7 is an example of a part of the configuration of the device, and does not limit the hardware configuration. The hardware configuration may include, for example, an input device such as a switch and a keyboard, a display device such as an LED, and an audio output device such as a speaker.

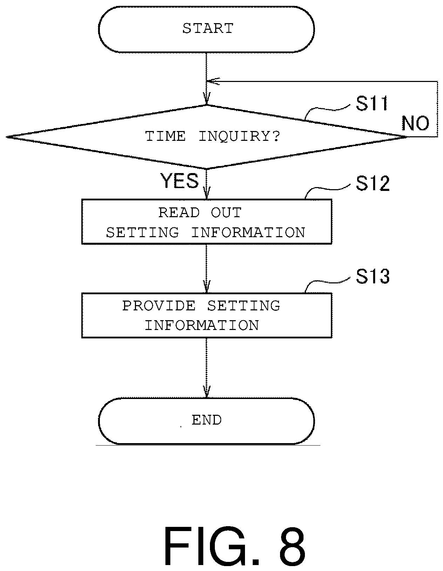

Next, with reference to FIGS. 8 to 12, the operations of the measurement device 1, measurement data management device 2, and setting information management device 5 will be described. FIGS. 8 to 12 are flowcharts illustrating an example of the operation of the measurement device control program, a setting information management device control program, or a setting information management device control program according to an embodiment. Although the flowcharts will be described below assuming that the subject of the operation is the measurement device 1, measurement data management device 2, or setting information management device 5, each operation may be performed in the functional portions of the devices described above.

FIG. 8 illustrates the operation of providing setting information by the setting information management device 5. In FIG. 8, the setting information management device 5 determines whether inquiry of the time at the measurement device 1 has been made (step S11). For example, the communication contents of the measurement device 1 are monitored and detected to determine whether the inquiry of time at the measurement device 1 has been made. If the setting information management device 5 determines that the inquiry of time has not been made (step S11: NO), the setting information management device 5 repeats the process in step S11 and waits for the detection of the inquiry of time.

In contrast, if the setting information management device 5 determines that the inquiry of time has been made (step S 11: YES), the setting information management device 5 reads out the setting information stored in the setting information management portion 52 (step S12), provides the measurement device 1 with the setting information (step S13), and completes the operation shown in the flowchart.

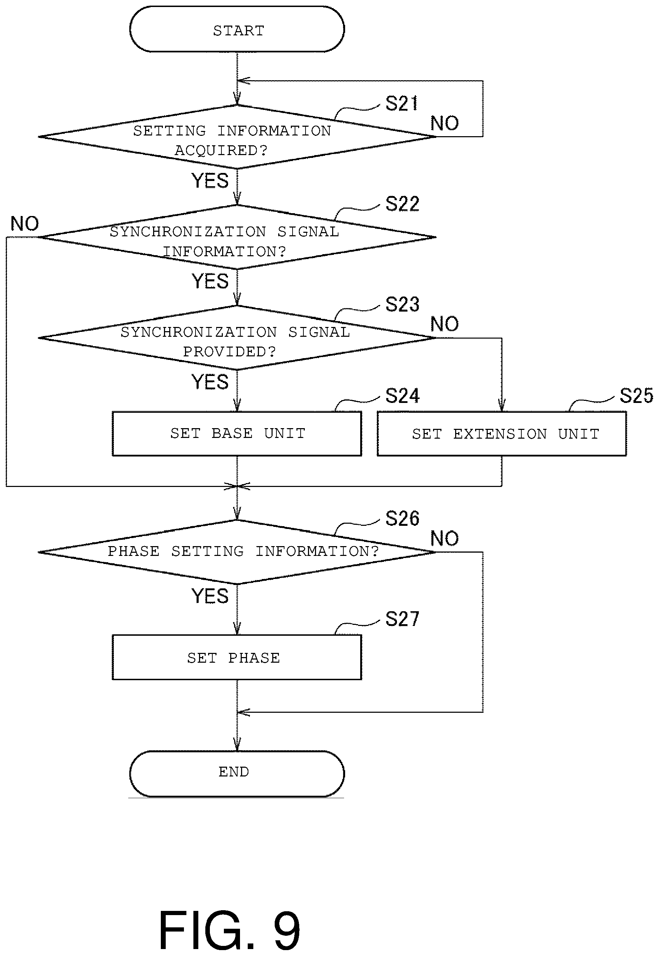

FIG. 9 illustrates the setting operation based on the setting information of the measurement device 1. Specifically, FIG. 9 is a flowchart illustrating an example of the operation of the measurement device according to an embodiment.

In FIG. 9, the measurement device 1 determines whether the setting information has been acquired (step S21). If the measurement device 1 determines that the setting information has not been acquired (step S21: NO), the measurement device 1 repeats the process in step S21 and waits for the acquisition of the setting information.

In contrast, if the measurement device 1 determines that the setting information has been acquired (step S21: YES), the measurement device 1 determines whether the acquired setting information includes information on the synchronization signal (step S22). If the measurement device 1 determines that the setting information includes the information on the synchronization signal (step S22: YES), the measurement device 1 determines whether the setting information includes a setting for providing the synchronization signal (step S23). If the measurement device 1 determines that the setting information includes a setting for providing the synchronization signal (step S23: YES), the measurement device 1 sets itself as a base unit that provides the synchronization signal (step S24). In contrast, if the measurement device 1 determines that the setting information does not include a setting for providing the synchronization signal (not a base unit) or that the setting information includes a setting for acquiring the synchronization signal (an extension unit) (step S23: NO), the measurement device 1 sets itself as an extension unit that acquires the synchronization signal (including a setting for failing to set itself as a base unit) (step S25).

If the measurement device 1 determines that the setting information does not include the information on the synchronization signal in step S22 (step S22: NO), or after the process in step S24 or step S25 is executed, the measurement device 1 determines whether the acquired setting information includes information on the phase setting (step S26). If the measurement device 1 determines that the acquired setting information includes the information on the phase setting (step S26: YES), the measurement device 1 sets the delay or advance of the waveform to be sampled (including the reversal of positive or negative of the waveform) based on the setting information (step S27). If the measurement device 1 determines that the acquired setting information does not include the information on the phase setting (step S26: NO), or after the process in step S27 is executed, the measurement device 1 completes the operation shown in the flowchart.

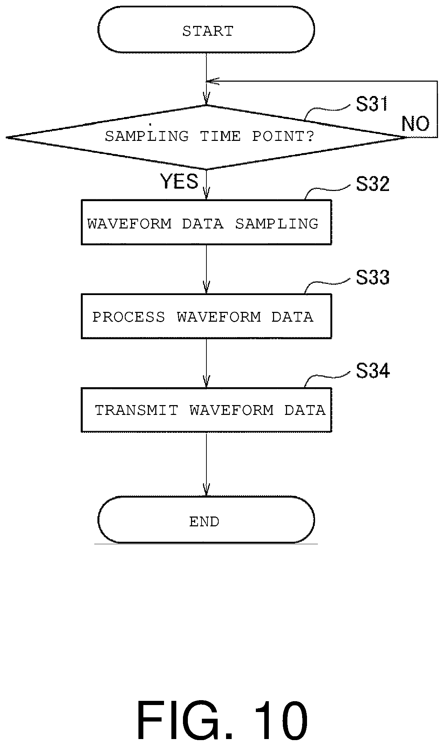

FIG. 10 illustrates the operation of sampling the waveform data in the measurement device 1. In FIG. 10, the measurement device 1 determines whether it is a sampling time (step S31). The sampling time may be determined based on whether it is a sampling time point (e.g., a predetermined zero crossing point) in the processing of the sampling slot. If the measurement device 1 determines that it is not a sampling time (step S31: NO), the device repeats the process in step S31 and waits for the sampling time point.

In contrast, if the measurement device 1 determines that it is sampling time (step S31: YES), the measurement device 1 samples the waveform data (voltage or current waveform) at the measurement point (step S32). The measurement device 1 processes the sampled waveform data (step S33). The measurement device 1 executes processing of the waveform data in a plurality of processing slots. The processing of the waveform data is directed to, for example, A/D conversion of analog data or normalization of the waveform data. The measurement device 1 transmits the processed waveform data to the measurement data management device 2 (step S34) and completes the operation shown in the flowchart.

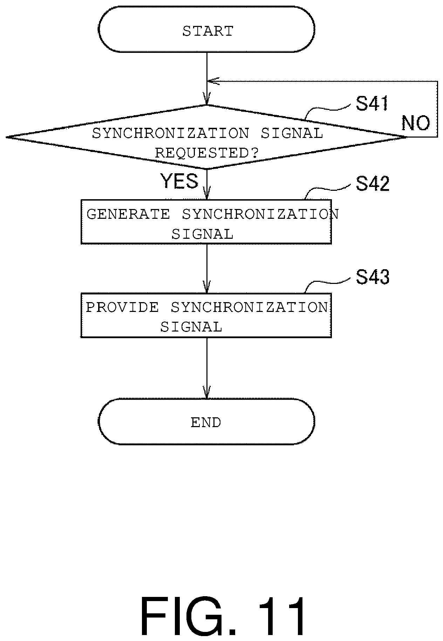

FIG. 11 illustrates a synchronization signal provision operation in the measurement device 1 (base unit). In FIG. 11, the measurement device 1 determines whether a request for providing a synchronization signal has been acquired from the measurement device 1 (extension unit) communicatively connected via the network (step S41). If the measurement device 1 determines that the request has not been acquired (step S41: NO), the base unit repeats the process in step S41 and waits for the acquisition of the request.

In contrast, if the measurement device 1 determines that the request has been acquired (step S41: YES), the base unit generates matter information based on the processing time point of the processing slot that is currently being executed (step S42). The base unit provides the extension unit with the generated synchronization signal (step S43) and completes the operation shown in the flowchart.

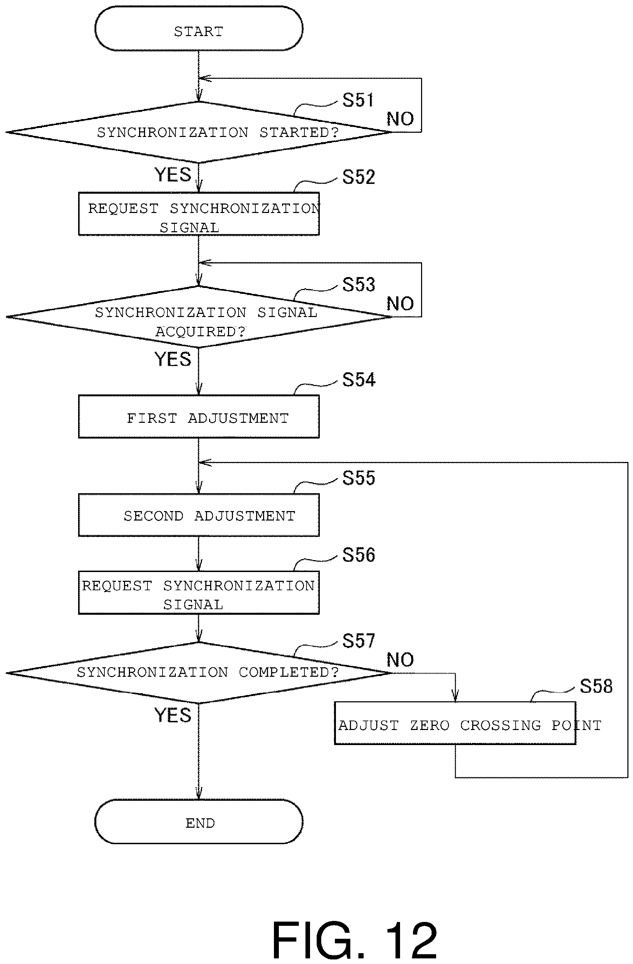

FIG. 12 illustrates the synchronization operation of the processing time point in the measurement device 1 (extension unit). In FIG. 12, the extension unit determines whether the synchronization of the processing time point is started (step S51). The start of synchronization occurs, for example, when the extension unit is turned on or a reset operation is performed. If the extension unit determines that synchronization does not start (step S51: NO), the extension unit repeats the process in step S51 and waits for the start of the synchronization.

In contrast, if the extension unit determines that the synchronization has started (step S51: YES), the extension unit requests the base unit to provide the synchronization signal (step S52). For example, the extension unit may recognize the address of the base unit on the network by receiving a first synchronization signal from the base unit, or the extension unit may transmit a command (e.g., a PING command) for checking the reachability of a node on an IP (Internet Protocol) network and request the provision of the synchronization signal to the IP address of the device that responds.

After executing the process in step S52, the extension unit determines whether it has acquired the synchronization signal (step S53). If the extension unit determines that the synchronization signal has not been acquired yet (step S53: NO), the extension unit waits for the acquisition of the synchronization signal until the timeout occurs.

In contrast, if the extension unit determines that the synchronization signal has been acquired (step S53: YES), the extension unit roughly adjusts the processing time point of the processing in the processing slot (first adjustment) based on the acquired synchronization signal (step S54). Next, the extension unit adjusts the processing time point in detail (second adjustment) based on the waveform (step S55).

Next, the extension unit requests the base unit to provide the synchronization signal (step S56). The process in step S56 is the same as the process in step S52.

Next, the extension unit determines whether the synchronization of the processing time point has been completed (step S57). The extension unit can determine whether the synchronization has been completed based on whether the zero crossing point described above is consistent with that of the base unit. If the extension unit determines that the synchronization of the processing time point has not been completed (step S57: NO), the extension unit adjusts the zero crossing point (step S58). After executing the process in step S58, the extension unit repeats the processes in steps S55 to S57 again to check whether the synchronization has been completed. In contrast, if the extension unit determines that the synchronization of the processing time point has been completed (step S57: YES), the extension unit completes the processing shown in the flowchart.

Although FIG. 12 illustrates the case where the extension unit requests the base unit to provide the synchronization signal, the base unit may voluntarily transmit the synchronization signal to the extension unit with, for example, the address of the extension unit included in the setting information.

The processes in the steps of the flowchart described in the present embodiment does not limit the order of the execution. For example, in the order of the execution of the processes that can be executed in parallel, any of the processes may be executed first.

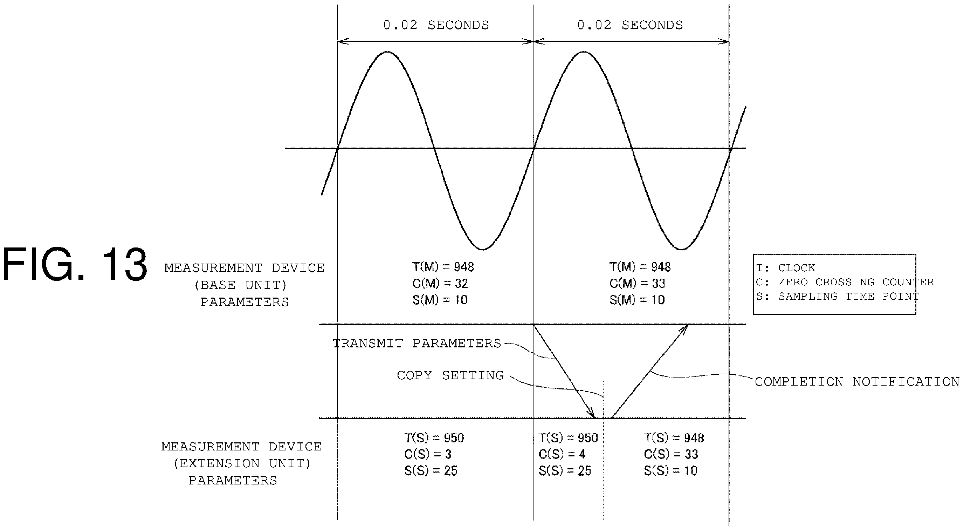

Next, with reference to FIG. 13, the adjustment of the processing time point of the measurement device 1 (extension unit) will be described. FIG. 13 is a diagram illustrating an example of an adjustment of processing time point of an extension unit according to an embodiment.

FIG. 13 shows the synchronization signal of the base unit and the synchronization signal of the extension unit for two cycles (0.02 seconds x two cycles) at a commercial frequency (50 Hz). T(M), C(M), and S(M) are the parameters of the synchronization signal in the base unit. T(S), C(S) and S(S) are the parameters of the synchronization signal in the extension unit.

T(M) indicates a value of the clock in the base unit. The value of the clock is acquired, for example, from the internal clock included in the base unit. T(S) indicates a value of the clock in the extension unit. The value of the clock is acquired, for example, from the internal clock included in the extension unit.

C(M) indicates a value of a zero crossing counter that counts the zero crossing points at which the positive and negative of the commercial waveform are reversed in the base unit. The value of the zero crossing counter may be acquired, for example, by counting the detected zero crossing points by the processor 12 for one second. For example, when the commercial frequency is 50 Hz, there are 50 zero-crossing points per second, and thus the value of the zero-crossing counter is from 0 to 49. In the same manner, C(S) indicates a value of a zero crossing counter that counts the zero crossing points at which the positive and negative of the commercial waveform are reversed in the extension unit.

S(M) is directed to a value indicating the sampling time point of the base unit. The sampling time point corresponds to a value of the zero crossing counter indicating the waveform starting point. S(S) is directed to a value indicating the sampling time point in the extension unit.

In the first cycle at the commercial frequency (the first 0.02 seconds shown), the parameters of the synchronization signal of the base unit are T(M) = 948, C(M) = 32, and S(M) = 10. In the second cycle at the commercial frequency (the second 0.02 seconds), the parameters of the synchronization signal of the base unit are T(M) = 948, C(M) = 33, and S(M) = 10. The zero crossing counter of the base unit is incremented by "1" for one cycle at the commercial frequency.

In the first cycle at the commercial frequency, the parameters of the synchronization signal of the extension unit are T(S) = 950, C(S) = 3, and S(S) = 25. That is, it is assumed that the synchronization signal of the base unit and the synchronization signal of the extension unit are out of sync in the first cycle. In the second cycle at the commercial frequency, the parameters of the synchronization signal of the extension unit are T(S) = 950, C(S) = 4, and S(S) = 25.

At the zero crossing point at which the second cycle begins, the base unit transmits the parameters of the synchronization signal to the extension unit. The extension unit acquires the transmitted parameters, copies the acquired parameters to its own synchronization signal, and sets them. As a result, the parameters of the synchronization signal of the extension unit are T(S) = 948, C(S) = 33, and S(S) = 10, which are the same as those of the base unit, adjusting the processing time point.

After setting the parameters of the synchronization signal of the extension unit, the extension unit transmits, to the base unit, the completion notification indicating that the parameters have been set. The base unit may recognize the successful setting of the parameters in the extension unit by receiving the completion notification. The base unit may be configured to perform error processing if it does not receive the completion notification within a predetermined time period after transmitting the parameters of the synchronization signal. The error processing is directed to, for example, retransmission of the parameters of the synchronization signal, or recording or notification of the occurrence of an error. If the base unit receives the completion notification within one cycle (within 0.02 seconds) at the commercial frequency from the transmission of the synchronization signal, the base unit is allowed to check that the transmitted synchronization signal has been correctly set within the same cycle range in the extension unit.

Since the adjustment of the processing time point shown in FIG. 13 is made for the base unit to transmit the synchronization signal at the zero crossing point where the second cycle starts as described above, the time point of setting the synchronization signal in the extension unit need to be within one cycle of the commercial frequency from the transmission of the synchronization signal. That is, the communication delay between the base unit and the extension unit need to be within at least one cycle of the commercial frequency. For example, the extension unit may measure the communication delay by sending a PING command and measuring the response time from the base unit to determine whether the adjustment of the processing time point shown in FIG. 13 can be executed.

In addition, the various processes according to the present embodiment described above may be performed by storing a program for embodying the functions that configure the device described according to the present embodiment in a computer-readable recording medium, and causing the computer system to read and execute the program stored in the recording medium. The "computer system" referred to here may include hardware such as operating systems and peripherals. In addition, the "computer system" shall also include the home page provision environment (or display environment) when using a WWW system. The term "computer-readable recording medium" refers to non-volatile memory such as flexible disks, optical and magnetic disks, ROMs, flash memory and other writable non-volatile memories, portable media such as CD-ROMs, and storage devices such as hard disks built into computer systems.

Further, "computer-readable recording medium" also includes those that retain the program for a certain amount of time, such as the volatile memory (e.g., Dynamic Random Access Memory (DRAM)) inside the computer system that serves as the server or client when the program is transmitted via a network such as the Internet or a communication line such as a telephone line. Moreover, the program above may be transmitted from the computer system in which the program is stored in a storage device, for example, to other computer systems via a transmission medium, or by transmission waves in the transmission medium. Here, the "transmission medium" for transmitting programs refers to a medium that has the function of transmitting information such as a network (communication network) such as the Internet or a communication circuit (communication line) such as a telephone circuit. Furthermore, the program above may be configured to embody a part of the functions described above. In addition, the program may be directed to a difference file (difference program) that embodies the functions described above in combination with a program already stored in the computer system.

Although the embodiments of the present invention have been described with reference to the drawings above, the specific configuration is not limited to the embodiments, and various modifications are also included without deviating the scope of the present invention.

### [List of Reference Numerals]

1: Measurement Device
10: Measurement System
11: Sampling Portion
111: Timer Counter
112: Wave Number Counter
113: Voltage Measurement Portion
114: Current Measurement Portion
12: Processor
13: Setting Information Acquisition Portion
14: Setting Retaining Portion
15: Operation Controller
16: Communication Controller
2: Measurement Data Management Device
21: Measurement Data Receiving Portion
22: Synchronous Measurement Data Storage
23: Synchronous Measurement Data Processor
24: Processing Data Storage
25: Measurement Data Provider
31: Refrigerator
32: Television
33: Electric Pot
34: Solar Photovoltaic Generator
35: Electric Vehicle
41: Smart Meter
42: Distribution Board
43: Power Conditioner
5: Setting Information Management Device
6: Time Providing Device
7: User Terminal
9: Network
101: CPU
102: RAM
103: ROM
104: Touch Panel
105: Communication Interface
106: Detector

## Claims

1. A measurement device (1) comprising:
a sampling portion (11) configured to sample a waveform of at least one of voltage and current at a measurement point in a power line at predetermined sampling time points;
a processor (12) configured to execute processing of the waveform sampled by the sampling portion, wherein the processing of the waveform is an A/D conversion of analog data or a normalization of the waveform data;
**characterized by** a setting information acquisition portion (13) configured to acquire setting information that determines an operation of the measurement device (1), wherein the setting information comprises:
setting information on a synchronization signal for synchronizing the sampling time points in a plurality of measurement devices, and/or
information on a setting of a phase of the waveform to be sampled;
a setting retention portion (14) configured to retain the setting information acquired by the setting information acquisition portion (13); and
an operation controller (15) configured to control the operation of the measurement device (1) based on the setting information retained in the setting retention portion (14).

2. The measurement device (1) according to claim 1, **characterized in that** the operation controller (15) executes an inquiry of time to be set in an internal clock to a time providing device (6) that provides a reference time, and
the setting information acquisition portion (13) acquires the setting information after the inquiry of time is executed.

3. The measurement device (1) according to claim 1 or 2, **characterized in that** the setting information acquisition portion (13) acquires the setting information from a setting information management device (5) communicably connected via a network.

4. The measurement device (1) according to any one of claims 1 to 3, **characterized in that** the sampling portion (11) samples the waveform at a sampling time point on a zero crossing point at which positive and negative of the waveform are reversed as reference.

5. The measurement device (1) according to any one of claims 1 to 4, **characterized in that** the operation controller (15) controls, when a setting on a synchronization signal for synchronizing the sampling time point is set in the setting information, the communication of the synchronization signal between the measurement device (1) and another measurement device (1) that samples a waveform at a measurement point in another power line.

6. The measurement device (1) according to claim 5, **characterized in that** the operation controller (15) controls communication of the synchronization signal including a value of an internal clock of the other measurement device (1) and a value of a wave number counter (112) that counts a zero crossing point at which positive and negative of the waveform to be sampled are reversed.

7. The measurement device (1) according to claim 5 or 6, **characterized in that** the operation controller (15) provides, when the setting in which the measurement device provides the synchronization signal is set in the setting information, the other measurement device (1) with the synchronization signal based on a processing time point of the processing.

8. The measurement device (1) according to claim 7, **characterized in that** the operation controller (15) provides a plurality of the other measurement devices (1) with the synchronization signal simultaneously.

9. The measurement device (1) according to claim 5 or 6, **characterized in that** the operation controller (15), when a setting for acquiring the synchronization signal is set in the setting information, acquires a synchronization signal from the other measurement device (1), and adjusts a processing time point of the processing based on the acquired synchronization signal.

10. The measurement device (1) according to claim 9, **characterized in that** the operation controller (15) adjusts the processing time point based on a zero crossing point at which positive and negative of the waveform are reversed.

11. The measurement device (1) according to any one of claims 1 to 10, **characterized in that** the operation controller (15), when a setting of a phase of the waveform to be sampled is set in the setting information, sets the phase of the waveform to be sampled by the sampling portion (11) based on the setting information.

12. The measurement device (1) according to any one of claims 1 to 11, wherein the sampling portion (11) comprises a detector (106) for detecting analog waveform data of current or voltage of the power line.

13. A method of controlling a measurement device (1) comprising a sampling portion (11), a processor (12), a setting information acquisition portion (13), a setting retention portion (14) and an operation controller (15),
the method **characterized by** comprising the steps of:
sampling, by the sampling portion (11), a waveform of at least one of voltage and current at a measurement point in a power line at predetermined sampling time points;
executing, by the processor (12), processing of the waveform sampled in the sampling step, wherein the processing of the waveform is an A/D conversion of analog data or a normalization of the waveform data;
acquiring, by the setting information acquisition portion (13), setting information that determines an operation of the measurement device (1), wherein the setting information comprises:
setting information on a synchronization signal for synchronizing the sampling time points in a plurality of measurement devices, and/or
information on a setting of a phase of the waveform to be sampled;
retaining, by the setting retention portion (14), the setting information acquired in the setting information acquisition step; and
controlling, by the operation controller (15), the operation of the measurement device (1) based on the setting information retained in the setting retaining step.

14. A computer-readable storage medium storing a program configured for causing the measurement device (1) according to any one of claims 1 to 12 to carry out the method according to claim 13.

## Patentansprüche

1. Messvorrichtung (1), umfassend:
einen Abtastteil (11), der dazu ausgebildet ist, eine Wellenform mindestens eines aus Spannung und Strom an einem Messpunkt in einer Stromleitung zu vorgegebenen Abtastzeitpunkten abzutasten;
einen Prozessor (12), der dazu ausgebildet ist, eine Verarbeitung der durch den Abtastteil abgetasteten Wellenform auszuführen, wobei die Verarbeitung der Wellenform eine A/D-Umwandlung analoger Daten oder eine Normalisierung der Wellenformdaten ist;
**gekennzeichnet durch**
einen Einstellinformationserfassungsteil (13), der dazu ausgebildet ist, Einstellinformationen zu erfassen, die einen Betrieb der Messvorrichtung (1) bestimmen, wobei die Einstellinformationen umfassen:
Einstellinformationen zu einem Synchronisationssignal zur Synchronisierung der Abtastzeitpunkte in einer Mehrzahl von Messvorrichtungen, und/oder
Informationen zu einer Einstellung einer Phase der abzutastenden Wellenform;
einen Einstellungsspeicherteil (14), der dazu ausgebildet ist, die durch den Einstellinformationserfassungsteil (13) erfassten Einstellinformationen zu speichern; und
eine Betriebssteuerung (15), die dazu ausgebildet ist, den Betrieb der Messvorrichtung (1) basierend auf den in dem Einstellungsspeicherteil (14) gespeicherten Einstellinformationen zu steuern.

2. Messvorrichtung (1) nach Anspruch 1, **dadurch gekennzeichnet, dass**
die Betriebssteuerung (15) eine Abfrage der in einem internen Taktgeber einzustellenden Zeit an eine Zeitgebervorrichtung (6), die eine Referenzzeit bereitstellt, durchführt, und
der Einstellinformationserfassungsteil (13) die Einstellinformationen erfasst, nachdem die Zeitabfrage ausgeführt wurde.

3. Messvorrichtung (1) nach Anspruch 1 oder 2, **dadurch gekennzeichnet, dass** der Einstellinformationserfassungsteil (13) die Einstellinformationen von einer
Einstellinformationserfassungsvorrichtung (5) erfasst, die über ein Netzwerk kommunikativ verbunden ist.

4. Messvorrichtung (1) nach einem der Ansprüche 1 bis 3, **dadurch gekennzeichnet, dass** der Abtastteil (11) die Wellenform zu einem Abtastzeitpunkt als Referenz an einem Nulldurchgangspunkt abtastet, an dem sich positive und negative Werte der Wellenform umkehren.

5. Messvorrichtung (1) nach einem der Ansprüche 1 bis 4, **dadurch gekennzeichnet, dass** die Betriebssteuerung (15), wenn in den Einstellinformationen eine Einstellung auf ein Synchronisationssignal zur Synchronisierung des Abtastzeitpunkts vorgenommen ist, die Kommunikation des Synchronisationssignals zwischen der Messvorrichtung (1) und einer anderen Messvorrichtung (1), die eine Wellenform an einem Messpunkt in einer anderen Stromleitung abtastet, steuert.

6. Messvorrichtung (1) nach Anspruch 5, **dadurch gekennzeichnet, dass** die Betriebssteuerung (15) die Kommunikation des Synchronisationssignals mit einem Wert eine internen Taktgebers der anderen Messvorrichtung (1) und einem Wert eines Wellenzahlzählers (112), der einen Nulldurchgangspunkt zählt, an dem sich positive und negative Werte der abzutastenden Wellenform umkehren, steuert.

7. Messvorrichtung (1) nach Anspruch 5 oder 6, **dadurch gekennzeichnet, dass**
die Betriebssteuerung (15), wenn die Einstellung, in der die Messvorrichtung das Synchronisationssignal bereitstellt, in den Einstellinformationen eingestellt ist, der anderen Messvorrichtung (1) das Synchronisationssignal basierend auf einem Verarbeitungszeitpunkt der Verarbeitung bereitstellt.

8. Messvorrichtung (1) nach Anspruch 7, **dadurch gekennzeichnet, dass** die Betriebssteuerung (15) das Synchronisationssignal gleichzeitig an eine Mehrzahl von anderen Messvorrichtungen (1) bereitstellt.

9. Messvorrichtung (1) nach Anspruch 5 oder 6, **dadurch gekennzeichnet, dass** die Betriebssteuerung (15), wenn in den Einstellinformationen eine Einstellung zum Erfassen des Synchronisationssignals eingestellt ist, ein Synchronisationssignal von der anderen Messvorrichtung (1) erfasst und einen Verarbeitungszeitpunkt der Verarbeitung basierend auf dem erfassten Synchronisationssignal anpasst.

10. Messvorrichtung (1) nach Anspruch 9, **dadurch gekennzeichnet, dass** die Betriebssteuerung (15) den Verarbeitungszeitpunkt basierend auf einem Nulldurchgangspunkt einstellt, an dem sich positive und negative Werte der Wellenform umkehren.

11. Messvorrichtung (1) nach einem der Ansprüche 1 bis 10, **dadurch gekennzeichnet, dass** die Betriebssteuerung (15), wenn in den Einstellinformationen eine Einstellung einer Phase der abzutastenden Wellenform eingestellt ist, die Phase der durch den Abtastteil (11) abzutastenden Wellenform basierend auf den Einstellinformationen einstellt.

12. Messvorrichtung (1) nach einem der Ansprüche 1 bis 11, wobei der Abtastteil (11) einen Detektor (106) zum Detektieren analoger Wellenformdaten von Strom oder Spannung der Stromleitung umfasst.

13. Verfahren zur Steuerung einer Messvorrichtung (1), die einen Abtastteil (11), einen Prozessor (12), einen Einstellinformationserfassungsteil (13), einen Einstellungsspeicherteil (14) und eine Betriebssteuerung (15) umfasst,
wobei das Verfahren **dadurch gekennzeichnet ist, dass** es die folgenden Schritte umfasst:
Abtasten, durch den Abtastteil (11), einer Wellenform mindestens eines aus Spannung und Strom an einem Messpunkt in einer Stromleitung zu vorbestimmten Abtastzeitpunkten;
Ausführen, durch den Prozessor (12), einer Verarbeitung der in dem Abtastschritt abgetasteten Wellenform, wobei die Verarbeitung der Wellenform eine A/D-Umwandlung analoger Daten oder eine Normalisierung der Wellenformdaten ist;
Erfassen, durch den Einstellinformationserfassungsteil (13), von Einstellinformationen, die einen Betrieb der Messvorrichtung (1) bestimmen, wobei die Einstellinformationen umfassen:
Einstellinformationen zu einem Synchronisationssignal zur Synchronisierung der Abtastzeitpunkte in einer Mehrzahl von Messvorrichtungen, und/oder
Informationen zu einer Einstellung einer Phase der abzutastenden Wellenform;
Speichern, durch den Einstellungsspeicherteil (14), der Einstellinformationen, die in dem Einstellinformationserfassungsschritt erfasst wurden; und
Steuern, durch die Betriebssteuerung (15), des Betriebs der Messvorrichtung (1) basierend auf den in dem Einstellungsspeicherschritt gespeicherten Einstellinformationen.

14. Computerlesbares Speichermedium, auf dem ein Programm gespeichert ist, das dazu ausgebildet ist, die Messvorrichtung (1) nach einem der Ansprüche 1 bis 12 zu veranlassen, das Verfahren nach Anspruch 13 auszuführen.

## Revendications

1. Dispositif de mesure (1) comprenant :
une partie d'échantillonnage (11) configurée pour échantillonner une forme d'onde d'au moins un de tension et de courant à un point de mesure dans une ligne électrique à des moments d'échantillonnage prédéterminés ;
un processeur (12) configuré pour exécuter un traitement de la forme d'onde échantillonnée par la partie d'échantillonnage, dans lequel le traitement de la forme d'onde est une conversion A/N de données analogiques ou une normalisation des données de forme d'onde ;
**caractérisé par**
une partie d'acquisition d'informations de réglage (13) configurée pour acquérir des informations de réglage qui déterminent un fonctionnement du dispositif de mesure (1), dans lequel les informations de réglage comprennent :
des informations de réglage sur un signal de synchronisation pour synchroniser les moments d'échantillonnage dans une pluralité de dispositifs de mesure, et/ou
des informations sur un réglage d'une phase de la forme d'onde à échantillonner ;
une partie de conservation de réglage (14) configurée pour conserver les informations de réglage acquises par la partie d'acquisition d'informations de réglage (13) ; et
un contrôleur de fonctionnement (15) configuré pour contrôler le fonctionnement du dispositif de mesure (1) sur la base des informations de réglage conservées dans la partie de conservation de réglage (14).

2. Dispositif de mesure (1) selon la revendication 1, **caractérisé en ce que**
le contrôleur d'opération (15) exécute une demande de temps à régler dans une horloge interne à un dispositif de fourniture de temps (6) qui fournit un temps de référence, et
la partie d'acquisition d'informations de réglage (13) acquiert les informations de réglage après que la demande de temps a été exécutée.

3. Dispositif de mesure (1) selon la revendication 1 ou 2, **caractérisé en ce que** la partie d'acquisition d'informations de réglage (13) acquiert les informations de réglage à partir d'un dispositif de gestion d'informations de réglage (5) connecté de manière communicative via un réseau.

4. Dispositif de mesure (1) selon une quelconque des revendications 1 à 3, **caractérisé en ce que** la partie d'échantillonnage (11) échantillonne la forme d'onde à un moment d'échantillonnage sur un point de passage par zéro auquel le positif et le négatif de la forme d'onde sont inversés comme référence.

5. Dispositif de mesure (1) selon une quelconque des revendications 1 à 4, **caractérisé en ce que** le contrôleur de fonctionnement (15) commande, lorsqu'un réglage sur un signal de synchronisation pour synchroniser le moment d'échantillonnage est réglé dans les informations de réglage, la communication du signal de synchronisation entre le dispositif de mesure (1) et un autre dispositif de mesure (1) qui échantillonne une forme d'onde à un point de mesure dans une autre ligne électrique.

6. Dispositif de mesure (1) selon la revendication 5, **caractérisé en ce que** le contrôleur de fonctionnement (15) commande la communication du signal de synchronisation comprenant une valeur d'une horloge interne de l'autre dispositif de mesure (1) et une valeur d'un compteur de nombres d'ondes (112) qui compte un point de passage par zéro auquel le positif et le négatif de la forme d'onde à échantillonner sont inversés.

7. Dispositif de mesure (1) selon la revendication 5 ou 6, **caractérisé en ce que**
le contrôleur de fonctionnement (15) fournit, lorsque le réglage dans lequel le dispositif de mesure fournit le signal de synchronisation est défini dans les informations de réglage, à l'autre dispositif de mesure(1)le signal de synchronisation sur la base d'un instant de traitement du traitement.

8. Dispositif de mesure (1) selon la revendication 7, **caractérisé en ce que** le contrôleur de fonctionnement (15) fournit simultanément le signal de synchronisation à une pluralité d'autres dispositifs de mesure (1).

9. Dispositif de mesure (1 )selon la revendication 5 ou 6, **caractérisé en ce que** le contrôleur de fonctionnement (15), lorsqu'un réglage pour acquérir le signal de synchronisation est défini dans les informations de réglage, acquiert un signal de synchronisation de l'autre dispositif de mesure (1), et ajuste un instant de traitement du traitement sur la base du signal de synchronisation acquis.

10. Dispositif de mesure (1) selon la revendication 9, **caractérisé en ce que** le contrôleur de fonctionnement (15) ajuste le moment de traitement sur la base d'un point de passage par zéro auquel le positif et le négatif de la forme d'onde sont inversés.

11. Dispositif de mesure (1) selon une quelconque des revendications 1 à 10, **caractérisé en ce que** le contrôleur de fonctionnement (15), lorsqu'un réglage d'une phase de la forme d'onde à échantillonner est réglé dans les informations de réglage, règle la phase de la forme d'onde à échantillonner par la partie d'échantillonnage (11) sur la base des informations de réglage.

12. Dispositif de mesure (1) selon une quelconque des revendications 1 à 11, dans lequel la partie d'échantillonnage (11) comprend un détecteur (106) pour détecter des données de forme d'onde analogique de courant ou de tension de la ligne électrique.

13. Procédé de commande d'un dispositif de mesure (1) comprenant une partie d'échantillonnage (11), un processeur (12), une partie d'acquisition d'informations de réglage (13), une partie de conservation de réglage (14) et un contrôleur de fonctionnement (15),
le procédé étant **caractérisé en ce qu'**il comprend les étapes consistant à:
échantillonner, par la partie d'échantillonnage (11), une forme d'onde d'au moins une tension et un courant à un point de mesure dans une ligne électrique à des moments d'échantillonnage prédéterminés;
exécuter, par le processeur (12), le traitement de la forme d'onde échantillonnée dans l'étape d'échantillonnage, dans lequel le traitement de la forme d'onde est une conversion A/N de données analogiques ou une normalisation des données de forme d'onde;
acquérir, par la partie d'acquisition d'informations de réglage (13), des informations de réglage qui déterminent un fonctionnement du dispositif de mesure (1), dans lequel les informations de réglage comprennent :
des informations de réglage sur un signal de synchronisation pour synchroniser les moments d'échantillonnage dans une pluralité de dispositifs de mesure, et/ou
des informations sur un réglage d'une phase de la forme d'onde à échantillonner;
conserver, par la partie de conservation de réglage (14), des informations de réglage acquises dans l'étape d'acquisition d'informations de réglage ; et
commander, par le contrôleur de fonctionnement (15), le fonctionnement du dispositif de mesure (1) sur la base des informations de réglage conservées dans l'étape de conservation de réglage.

14. Support de mémorisation lisible par ordinateur mémorisant un programme configuré pour amener le dispositif de mesure (1) selon une quelconque des revendications 1 à 12 à exécuter le procédé selon la revendication 13.
